# EUROPÄISCHE PATENTANMELDUNG

(11) **EP 1 132 747 A2**
(43) Veröffentlichungstag der Anmeldung: **12.09.2001**
(21) Anmeldenummer: 01105567.0
(22) Anmeldetag: 06.03.2001
(51) Int. Cl.: G01R 31/18

(54) **Hochspannungsprüfvorrichtung**

(30) Priorität: 10.03.2000 DE 10011466
(71) Anmelder: ETL Prüftechnik GmbH, 70825 Korntal (DE)
(72) Erfinder: Luithlen, Roland, 70597 Stuttgart (DE)
(74) Vertreter: Patentanwalts-Partnerschaft Rotermund + Pfusch

(57) **Zusammenfassung**

Die Erfindung betrifft eine Vorrichtung (1) zum Durchführen einer Hochspannungsprüfung bei einem elektrischen Gerät (Prüfling), umfassend mindestens eine Kontaktiereinheit (3) mit einer Elektrode (11), an die über ein Hochspannungskabel (9) ein Hochspannungspotential anlegbar ist und die zur Durchführung der Hochspannungsprüfung mit dem Prüfling in Kontakt gebracht wird, und mit einem Schalter (12), an dessen Eingang (13) und Ausgang (14) bei unbetätigtem Schalter (12) über einen mit einer Steuerung (4) verbundenen Signalkreis eine Niederspannungspotentialdifferenz anliegt und der bei Betätigung die Erzeugung eines elektrischen Signals bewirkt, das einen Kontakt zwischen Elektrode (11) und Prüfling signalisiert und über den Signalkreis der Steuerung (4) zugeleitet wird, wobei die Steuerung (4) so ausgebildet ist, daß eine Prüfprozedur erst dann beginnt, wenn der Schalter (12) betätigt ist.

Um bei einer derartigen Vorrichtung den Aufbau zu vereinfachen, wird vorgeschlagen, daß sich Eingang (13) und Ausgang (14) des Schalters (12) zumindest bei am Hochspannungskabel (9) anliegenden Hochspannungspotential etwa auf demselben Potentialniveau befinden wie das Hochspannungskabel (9).

## Beschreibung

Die Erfindung betrifft eine Vorrichtung zum Durchführen einer Hochspannungsprüfung bei einem elektrischen Gerät, dem sogenannten "Prüfling", mit den Merkmalen des Oberbegriffs des Anspruchs 1.

Aus dem Firmenprospekt "TECHNOLOGY IN ADVANCE" der Firma Schleich GmbH in D-58675. Hemer, Seiten 1 und 27 ist eine solche Vorrichtung bekannt, die zwei als Prüfpistole ausgebildete Kontaktiereinheiten aufweist. Die Prüfpistolen enthalten jeweils eine Elektrode, an die über ein Hochspannungskabel ein Hochspannungspotential anlegbar ist und die zur Durchführung der Hochspannungsprüfung mit dem Prüfling in Kontakt gebracht wird. In eine der Prüfpistolen ist ein Schalter integriert, der manuell mit dem Abzug der Prüfpistole betätigt wird. Solange der Schalter unbetätigt ist, liegt am Schalter bzw. an dessen Eingang und Ausgang eine Niederspannungspotentialdifferenz von ca. 5 Volt an. Eingang und Ausgang des Schalters sind dazu mit zwei separaten Signalkabeln eines Signalkreises mit einer Steuerung verbunden, die den Signalkreis auswertet. Bei einer Betätigung des Schalters wird ein elektrisches Signal erzeugt, das einen Kontakt zwischen Elektrode und Prüfling signalisiert und über den Signalkreis der Steuerung zugeleitet wird. Die Steuerung ist dabei so ausgebildet, daß eine Prüfprozedur erst dann beginnt, wenn der Schalter betätigt ist.

Das durch die Betätigung des Schalters ausgelöste Signal wird bei einer derartigen Vorrichtung benötigt, um gewährleisten zu können, daß eine vorgegebene Prüfprozedur erst dann beginnt, wenn der Prüfer, der die Prüfpistolen handhabt, der Ansicht ist, daß die Elektroden mit dem Prüfling in Kontakt stehen. Bei der bekannten Vorrichtung befinden sich die zum Schalter führenden Signalkabel des Signalkreises auf einem Niederspannungsniveau, um ein entsprechendes Schaltsignal beim Betätigen des Schalters zu erzeugen. Da die Potentialdifferenz am Eingang und Ausgang des Schalters im Bereich eines niedrigen Spannungswertes gewählt ist, kann ein relativ preiswerter Schalter verwendet werden, außerdem eignet sich das damit erzeugbare Signal besonders zur Verarbeitung in der Steuerung. Die beiden Signalkabel des Signalkreises und das Hochspannungskabel sind in einem gemeinsamen Kabelmantel untergebracht, um die Handhabung der Prüfpistole zu vereinfachen. Hierbei entsteht jedoch der Nachteil, daß während der Hochspannungsprüfung ein Ableitstrom durch die Kapazität zwischen der Hochspannungsleitung und den Signalleitungen entsteht, der das Prüfungsergebnis beeinflussen und sicherheitstechnische Probleme verursachen kann. Die Größe des sich ausbildenden Ableitstromes hängt dabei von der Kabellänge ab, so daß, wenn ein Maximalwert für den Ableitstrom nicht überschritten werden soll, die Kabellänge begrenzt ist.

Darüber hinaus ist es aufgrund des großen Potentialunterschieds zwischen den Signalkabeln und dem Hochspannungskabel nicht ohne weiteres möglich, einen sicheren mehrpoligen Stecker zu konstruieren, mit dem sowohl das Hochspannungskabel als auch die Signalkabel des Signalkreises gleichzeitig an die Vorrichtung angeschlossen werden können. Dementsprechend sind bei der bekannten Prüfpistole die beiden Signalkabel des Signalkreises mit einem gemeinsamen Klinkenstecker ausgestattet, während das Hochspannungskabel einen separaten Stecker aufweist.

Schließlich müssen das Hochspannungskabel und der Signalkreis sorgfältig gegeneinander isoliert sein, um elektrische Durchschläge aufgrund der dazwischen herrschenden großen Potentialdifferenz zu vermeiden.

Die vorliegende Erfindung beschäftigt sich mit dem Problem, für eine Vorrichtung der eingangs genannten Art einen vereinfachten Aufbau anzugeben.

Dieses Problem wird erfindungsgemäß durch eine Vorrichtung mit den Merkmalen des Anspruchs 1 gelöst.

Die Erfindung beruht auf dem allgemeinen Gedanken, den Signalkreis und das Hochspannungskabel auf demselben oder annähernd demselben Potential zu betreiben. Durch diese Maßnahme besteht zwischen dem Signalkreis und dem Hochspannungskabel keine große Potentialdifferenz, so daß Ableitströme durch die Kapazität zwischen dem Hochspannungskabel und dem Signalkreis reduziert werden. Die Begrenzung der Kabellänge reduziert sich dementsprechend, so daß erheblich längere Kabel ausgebildet werden können. Außerdem ist es nun möglich, einen gemeinsamen Stecker für das Hochspannungskabel und den Signalkreis zu konstruieren, so daß sich auch hier eine Vereinfachung ergibt.

Entsprechend einer bevorzugten Ausführungsform kann die Steuerung der Vorrichtung so ausgebildet sein, daß sich Eingang und Ausgang des Schalters auf einem Niederspannungsniveau befinden, wenn das Hochspannungspotential nicht am Hochspannungskabel anliegt. Dementsprechend herrscht auch vor und nach der Hochspannungsprüfung, das heißt, solange keine Hochspannung am Hochspannungskabel anliegt, eine relativ kleine Spannungsdifferenz zwischen dem Signalkreis und dem Hochspannungskabel. Es ist klar, daß die Steuerung das Potentialniveau am Schalter bzw. am Eingang und Ausgang des Schalters dann in Abhängigkeit des durch Betätigen des Schalters erzeugten Signalwertes umschaltet und zwar auf Hochspannungsniveau, wenn der Schalter betätigt wird und die Hochspannung an das Hochspannungskabel angelegt wird, bzw. auf Niederspannungsniveau, wenn der Schalter nicht betätigt ist und dementsprechend die Hochspannung nicht am Hochspannungskabel anliegt.

Gemäß einer besonders vorteilhaften Ausführungsform weist der Signalkreis zwei Signalleitungen auf, zwischen denen bei unbetätigtem Schalter die Niederspannungspotentialdifferenz herrscht, wobei die eine Signalleitung durch ein Signalkabel gebildet ist und wobei die andere Signalleitung durch das Hochspannungskabel gebildet ist. Bei dieser Variante wird zweckmäßig für eine Signalleitung des Signalkreises das Hochspannungskabel verwendet, wodurch ein zweites Signalkabel entfallen kann. Dementsprechend kann auch der Anschluß an die Vorrichtung mittels eines entsprechenden Steckers vereinfacht werden.

Bei einer besonders vorteilhaften Ausführungsform kann die Elektrode in der Kontaktiereinheit bidirektional verstellbar gelagert sein und außerdem so mit dem Schalter zusammenwirken, daß die Elektrode sich beim Kontakt mit dem Prüfling verstellt und dadurch den Schalter betätigt. Während es bei einem herkömmlichen, durch den Abzug der Pistole betätigten Schalter auf das Geschick des Prüfers ankommt, der daher subjektiv entscheidet ob ein Kontakt zwischen Elektrode und Prüfling vorliegt oder nicht, gewährleistet die vorgeschlagene Variante, daß nur dann der Schalter betätigt wird, wenn tatsächlich die Elektrode mit dem Prüfling in Kontakt steht. Die Meßsicherheit und Zuverlässigkeit der dadurch erzielten Prüfergebnisse wird dementsprechend verbessert.

Weitere wichtige Merkmale und Vorteile der erfindungsgemäßen Vorrichtung ergeben sich aus den Unteransprüchen, aus den Zeichnungen und aus der zugehörigen Figurenbeschreibung anhand der Zeichnungen.

Es versteht sich, daß die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert.

Es zeigen, jeweils schematisch,
- Fig. 1: eine schaltplanartige Prinzipdarstellung einer erfindungsgemäßen Vorrichtung,
- Fig. 2: eine Ansicht wie in Fig. 1, jedoch einer anderen Ausführungsform, und
- Fig. 3: eine Prinzipdarstellung einer Kontaktiereinheit, die als Prüfpistole ausgebildet ist.

Unter Hochspannung wird im vorliegenden Zusammenhang insbesondere eine Spannung von mindestens 1.000 Volt verstanden, während eine Niederspannung regelmäßig weniger als 48 Volt, vorzugsweise etwa 5 Volt beträgt.

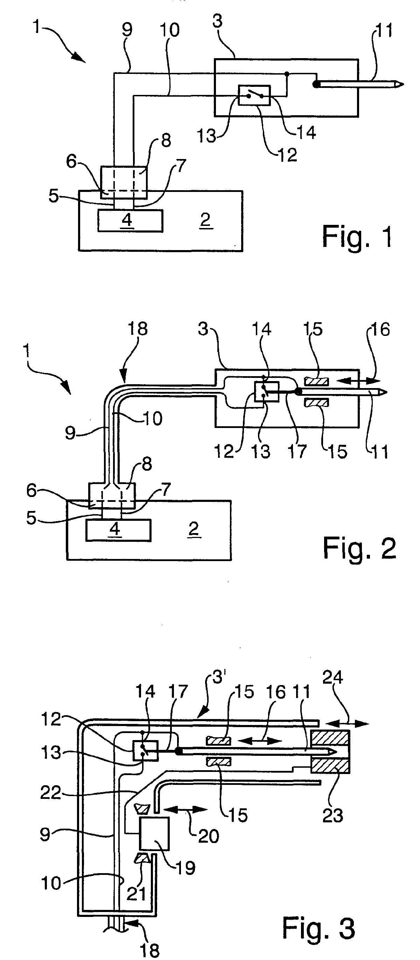

Entsprechend den Fig. 1 und 2 weist eine erfindungsgemäße Vorrichtung 1 ein Basisgerät 2 und wenigstens eine Kontaktiereinheit 3 auf. Es ist klar, daß die Vorrichtung 1 auch zwei oder mehr Kontaktiereinheiten 3 aufweisen kann.

Das stark vereinfacht dargestellte Basisgerät 2 enthält zumindest eine Steuerung 4, die über eine erste Verbindungsleitung 5 mit einen entsprechenden Kontakt einer Steckdose 6 verbunden ist. Mit einer zweiten Verbindungsleitung 7 ist die Steuerung 4 mit einem entsprechenden anderen Kontakt der Steckdose 6 verbunden. In die Steckdose 6 ist ein Stecker 8 eingesteckt, der gemeinsam am Ende eines Hochspannungskabels 9 und eines Signalkabels 10 ausgebildet ist.

Im Inneren der Kontaktiereinheit 3 ist das Hochspannungskabel 9 an eine Elektrode 11 angeschlossen, die an ein nicht dargestelltes elektrisches Gerät zur Anlage gebracht wird, wenn dieses als "Prüfling" bezeichnete elektrische Gerät z.B. hinsichtlich seiner Isolierung geprüft werden soll. Die Kontaktiereinheit 3 weist außerdem einen Schalter 12 auf, dessen Eingang 13 mit dem Signalkabel 10 verbunden ist und dessen Ausgang 14 erfindungsgemäß mit dem Hochspannungskabel 9 verbunden ist. Es ist klar, daß die Bezeichnungen "Eingang" und "Ausgang" hier austauschbar sind.

Bei der speziellen Ausführungsform gemäß Fig. 2 ist die Elektrode 11 in der Kontaktiereinheit 3 bidirektional verstellbar gelagert, wobei sich die Elektrode 11 parallel zu ihrer Längsachse verstellt. Eine entsprechende Lagerung ist nur symbolisch dargestellt und mit 15 bezeichnet. Die bidirektionale Längsverstellbarkeit der Elektrode 11 ist durch einen Doppelpfeil 16 symbolisiert.

Die Elektrode 11 ist mit dem Schalter 12. über eine Kopplung 17 verbunden, wodurch die Elektrode 11 zur Betätigung des Schalters 12 mit diesem zusammenwirken kann. Wenn sich die Elektrode 11 in die Kontaktiereinheit 3 hineinverstellt, betätigt sie über die Kopplung 17 den Schalter 12, wodurch Eingang 13 und Ausgang 14 des Schalters 12 miteinander verbunden werden.

Bei der in Fig. 2 wiedergegebenen Ausführungsform sind das Hochspannungskabel 9 und das Signalkabel 10 zu einem gemeinsamen Kabelmantel 18 zusammengefaßt, wodurch sich das Handling der Hochspannungsprüfvorrichtung 1 vereinfacht.

Die erfindungsgemäße Vorrichtung 1 arbeitet wie folgt:

Solange keine Hochspannungsprüfung stattfindet, bewirkt die Steuerung 4, daß einerseits am Hochspannungskabel 9 keine Hochspannung anliegt und daß andererseits zwischen dem Hochspannungskabel 9 und dem Signalkabel 10 eine Niederspannungspotentialdifferenz besteht. Diese Potentialdifferenz kann z.B. 5 Volt betragen. Beispielsweise liegen am Hochspannungskabel 5 Volt und am Signalkabel 0 Volt an.

Die Kontaktiereinheit 3 kann beispielsweise in einer automatisch arbeitenden Prüfanlage zum Einsatz kommen und dementsprechend selbsttätig gegen einen Prüfling, z.B. ein Bügeleisen, gefahren werden, damit die Elektrode 11 mit einem zu überprüfenden Bestandteil des Prüflings in Kontakt kommt. Beispielsweise soll die elektrische Isolation eines Gehäuses des Prüflings überprüft werden. Wenn die selbsttätig arbeitende Prüfanlage davon ausgeht, daß die Elektrode 11 in Kontakt mit dem Prüfling steht, wird der Schalter 12 betätigt, so daß Eingang 13 und Ausgang 14 miteinander verbunden sind.

Auf diese Weise wird ein elektrisches Signal erzeugt, das über das Signalkabel 10 bzw. über das Hochspannungskabel 9 an die Steuerung 4 weitergeleitet wird und von dieser ausgewertet werden kann. Sobald die Steuerung 4 das durch den geschlossenen Schalter 12 verursachte Signal empfängt, geht die Steuerung 4 davon aus, daß ein Kontakt zwischen der Elektrode 11 und dem Prüfling besteht und startet die vorgesehene Prüfprozedur. Das Signal für den Kontakt zwischen Elektrode 11 und Prüfling ist für eine ordnungsgemäße Hochspannungsprüfung von besonderer Bedeutung, da die Hochspannungsprüfung, die beispielsweise verschiedene Spannungen und verschiedene Zeitabläufe beinhaltet, genau dokumentiert werden muß.

Während der Hochspannungsprüfung bewirkt die Steuerung 4, daß am Hochspannungskabel 9 die Prüfspannung mit Hochspannungspotential anliegt. Gleichzeitig bewirkt die Steuerung 4, daß auch das Signalkabel 10 auf einem Hochspannungspotential liegt, das etwa gleich groß ist, wie das Potential des Hochspannungskabels 9. Die Steuerung 4 ist so ausgebildet, daß stets etwa dieselbe niedrige Potentialdifferenz zwischen dem Hochspannungskabel 9 und dem Signalkabel 10 vorliegt. Wenn beispielsweise am Hochspannungskabel 9 1.000 Volt anliegen, wird das Signalkabel 9 mit 995 Volt beaufschlagt, so daß die Potentialdifferenz auch hier wieder etwa 5 Volt beträgt. Entsprechendes gilt für andere Hochspannungswerte, die im Rahmen der Hochspannungsprüfung durchlaufen werden können. Auf diese Weise kann gewährleistet werden, daß nur minimale Ableitströme aufgrund kapazitiver Effekte zwischen den Kabeln 9 und 10 auftreten, wodurch die Hochspannungsprüfung eine besonders hohe Genauigkeit und Zuverlässigkeit aufweist.

Wenn die Hochspannungsprüfung beendet ist, wird der Schalter 12 wieder geöffnet, was von der Steuerung 4 erkannt wird, so daß diese die Hochspannungspotentiale am Hochspannungskabel 9 und am Signalkabel 10 wieder auf Niederspannungspotentiale reduziert.

Während bei der Ausführungsform gemäß Fig. 1 der Schalter 12 manuell oder im Rahmen einer automatischen Prüfanlage programmgesteuert betätigt wird, erfolgt die Betätigung des Schalters 12 bei der Variante gemäß Fig. 2 selbsttätig dann, wenn die Elektrode 11 durch ihren Kontakt mit dem Prüfling hinreichend in die Kontaktiereinheit 3 hineinverstellt wird.

Die Elektrode 11 ist dabei vorzugsweise mittels nicht dargestellter Federmittel nach außen vorgespannt, so daß der Schalter 12 beim Entfernen der Kontaktiereinheit 3 vom Prüfling selbsttätig wieder geöffnet wird.

Entsprechend einer besonders vorteilhaften Ausführungsform kann die Kontaktiereinheit 3' entsprechend Fig. 3 als manuell betätigbare Prüfpistole ausgebildet sein. Die Prüfpistole oder Kontaktiereinheit 3' weist hier ebenfalls eine Lagerung 15 für eine bidirektionale Verstellbarkeit der Elektrode 11 auf. Dementsprechend ist auch hier die Elektrode 11 über die Kopplung 17 mit dem Schalter 12 verbunden, um diesen durch bidirektionale Verstellungen betätigen zu können.

Die pistolenförmige Kontaktiereinheit 3' weist einen Abzug 19 auf, der entsprechend einem Doppelpfeil 20 in der Kontaktiereinheit 3' verstellbar gelagert ist. Entsprechende Lager sind bei 21 angedeutet. Anstelle einer linearen Verstellbarkeit kann der Abzug 19 auch schwenkverstellbar an der Kontaktiereinheit 3' gelagert sein. Der Abzug 19 ist über eine nur symbolisch dargestellte Kopplung 22 mit einem Schutzrohr 23 antriebsverbunden, derart, daß eine Betätigung des Auslösers 19 das Schutzrohr 23 aus der in Fig. 3 dargestellten Sicherungsposition in eine Entsicherungsposition verstellt. Das Schutzohr 23 umgibt die Elektrode 11 in ihrem vorderen Endbereich. In seiner Sicherungsposition überragt der das Schutzrohr 23 das vordere Ende der Elektrode 11, so daß kein direkter Kontakt mit der Elektrode 11 möglich ist. In der eingefahrenen Entsicherungsposition ragt die Elektrodenspitze über das Schutzrohr 23 vor, wodurch ein direkter Kontakt mit der Elektrode 11 ermöglicht wird. Die Verstellbarkeit des Schutzrohres 23 ist durch einen Doppelpfeil 24 symbolisch dargestellt. Auch hier sind vorzugsweise nicht dargestellte Federmittel vorgesehen, die das Schutzrohr 23 in seine Sicherungsposition vorspannen.

## Patentansprüche

1. Vorrichtung zum Durchführen einer Hochspannungsprüfung bei einem elektrischen Gerät (Prüfling), umfassend mindestens eine Kontaktiereinheit (3) mit einer Elektrode (11), an die über ein Hochspannungskabel (9) ein Hochspannungspotential anlegbar ist und die zur Durchführung der Hochspannungsprüfung mit dem Prüfling in Kontakt gebracht wird, und mit einem Schalter (12), an dessen Eingang (13) und Ausgang (14) bei unbetätigtem Schalter (12) über einen mit einer Steuerung (4) verbundenen Signalkreis eine Niederspannungspotentialdifferenz anliegt und der bei Betätigung die Erzeugung eines elektrischen Signals bewirkt, das einen Kontakt zwischen Elektrode (11) und Prüfling signalisiert und über den Signalkreis der Steuerung (4) zugeleitet wird, wobei die Steuerung (4) so ausgebildet ist, daß eine Prüfprozedur erst dann beginnt, wenn der Schalter (12) betätigt ist,
**dadurch gekennzeichnet,**
daß sich Eingang (12) und Ausgang (14) des Schalters (12) zumindest bei am Hochspannungskabel (9) anliegenden Hochspannungspotential etwa auf demselben Potentialniveau befinden wie das Hochspannungskabel (9).

2. Vorrichtung nach Anspruch 1,
**dadurch gekennzeichnet,**
daß die Steuerung (4) so ausgebildet ist, daß sich Eingang (13) und Ausgang (14) des Schalters (12) auf einem Niederspannungsniveau befinden, wenn das Hochspannungspotential nicht am Hochspannungskabel (9) anliegt.

3. Vorrichtung nach Anspruch 1 oder 2,
**dadurch gekennzeichnet,**
daß der Signalkreis zwei Signalleitungen aufweist, zwischen denen bei unbetätigtem Schalter (12) die Niederspannungspotentialdifferenz herrscht, wobei die eine Signalleitung durch ein Signalkabel (10) gebildet ist und wobei die andere Signalleitung durch das Hochspannungskabel (9) gebildet ist.

4. Vorrichtung nach Anspruch 3,
**dadurch gekennzeichnet,**
daß das Signalkabel (10) und das Hochspannungskabel (9) in einem gemeinsamen Kabelmantel (18) untergebracht sind.

5. Vorrichtung nach Anspruch 3 oder 4,
**dadurch gekennzeichnet,**
daß das Signalkabel (10) und das Hochspannungskabel (9) einen gemeinsamen Stecker (8) aufweisen.

6. Vorrichtung nach einem der Ansprüche 1 bis 5,
**dadurch gekennzeichnet,**
daß die Elektrode (11) in der Kontaktiereinheit (3) bidirektional verstellbar gelagert ist und so mit dem Schalter (12) zusammenwirkt, daß die Elektrode (11) sich beim Kontakt mit dem Prüfling verstellt und dadurch den Schalter (12) betätigt.

7. Vorrichtung nach einem der Ansprüche 1 bis 6,
**dadurch gekennzeichnet,**
daß die Kontaktiereinheit (3') als Prüfpistole ausgebildet ist.
